# EUROPEAN PATENT APPLICATION

(11) **EP 4 464 818 A1**
(43) Date of publication of application: **20.11.2024**
(21) Application number: 24161815.6
(22) Date of filing: 06.03.2024
(51) Int. Cl.: C23C 16/34, C23C 16/44, C23C 16/455, H01L 21/285, C23C 16/52

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 31.03.2023 JP 2023057883
(71) Applicant: Kokusai Electric Corporation, Tokyo 101-0045 (JP)
(72) Inventor: MATSUNO, Yutaka, Toyama-shi, Toyama, 939-2393 (JP); SEINO, Atsuro, Toyama-shi, Toyama, 939-2393 (JP); OGAWA, Arito, Toyama-shi, Toyama, 939-2393 (JP)
(74) Representative: Bardehle Pagenberg Partnerschaft mbB Patentanwälte Rechtsanwälte

(57) **Abstract**

A technique includes forming a film containing a first element and a second element different from the first element on a substrate (200) by performing a process a predetermined number of times, the process including: (a) supplying a first gas containing the first element and a halogen element to the substrate (200); (b) supplying a second gas containing the second element to the substrate (200); (c) supplying a third gas containing a third element and having a reducing character to the substrate (200); and (d) supplying a fourth gas containing a fourth element and having a reducing character to the substrate (200), wherein (a) and (d) are performed consecutively, and (b) and (c) are performed consecutively.

## Description

### CROSS-REFERENCE TO RELATED APPLICATION

This application is based upon and claims the benefit of priority from Japanese Patent Application No. 2023-057883, filed on March 31, 2023, the entire contents of which are incorporated herein by reference.

### TECHNICAL FIELD

The present disclosure relates to a method of processing a substrate, a method of manufacturing a semiconductor device, a substrate processing apparatus, and a program.

### BACKGROUND

A process of manufacturing a semiconductor device is a process of forming a film on the surface of a substrate.

In the process of forming a film, a film formation speed (deposition rate) may decrease.

### SUMMARY

Some embodiments of the present disclosure provide a technique capable of improving a deposition rate.

According to one embodiment of the present disclosure, there is provided a technique that includes: forming a film containing a first element and a second element different from the first element on the substrate by performing a process a predetermined number of times, the process including: (a) supplying a first gas containing the first element and a halogen element to the substrate; (b) supplying a second gas containing the second element to the substrate; (c) supplying a third gas containing a third element and having a reducing character to the substrate; and (d) supplying a fourth gas containing a fourth element and having a reducing character to the substrate, wherein (a) and (d) are performed consecutively, and (b) and (c) are performed consecutively.

### BRIEF DESCRIPTION OF DRAWINGS

The accompanying drawings, which are incorporated in and constitute a part of the specification, illustrate embodiments of the present disclosure.
FIG. 1 is a longitudinal sectional view showing an outline of a substrate processing apparatus according to an embodiment.
FIG. 2 is a schematic cross-sectional view taken along line A-A in FIG. 1.
FIG. 3 is a schematic configuration view of a controller of the substrate processing apparatus according to the embodiment, in which a control system of the controller is shown in a block diagram.
FIG. 4A is a diagram showing a timing of gas supply in the embodiment.
FIG. 4B is a diagram showing a timing of gas supply in Modification 1 of the embodiment.
FIG. 4C is a diagram showing a timing of gas supply in Modification 2 of the embodiment.
FIG. 5A is a diagram showing a timing of gas supply in Comparative Example 1 of an experimental example.
FIG. 5B is a diagram showing a timing of gas supply in Comparative Example 2 of the experimental example.
FIG. 5C is a diagram showing a timing of gas supply in Comparative Example 3 of the experimental example.
FIG. 6 is a diagram showing an outline of a portion added to the substrate processing apparatus of FIG. 1 and its surroundings in the embodiment.
FIG. 7 is a diagram showing the results of XRD measurement in the experimental example.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

### <Embodiment>

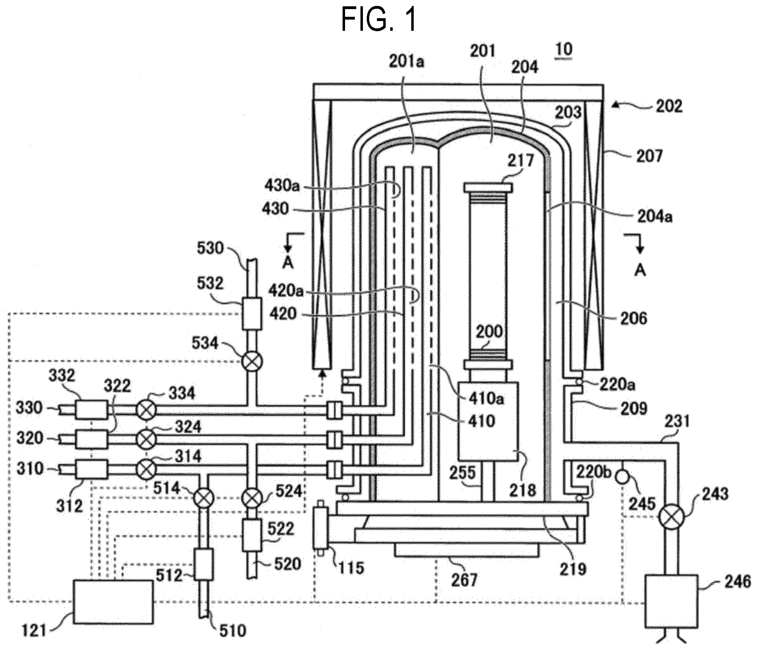

One embodiment of the present disclosure will now be described with reference to FIGS. 1 to 3, 4A, and 6. The drawings used in the following description are all schematic, and the dimensional relationship, ratios, and the like of various elements shown in figures do not always match the actual ones. Further, the dimensional relationship, ratios, and the like of various elements between plural figures do not always match each other.

### (1) Configuration of Substrate Processing Apparatus

A substrate process apparatus 10 includes a process furnace 202 in which a heater 207 as a heating means (a heating mechanism or a heating system) is installed. The heater 207 has a cylindrical shape and is supported by a heat base (not shown) as a support plate so as to be vertically installed.

An outer tube 203 forming a reaction container (a process container) is disposed inside the heater 207 to be concentric with the heater 207. The outer tube 203 is made of, for example, a heat resistant material such as quartz (SiO₂) or silicon carbide (SiC) and has a cylindrical shape with its upper end closed and its lower end opened. A manifold (an inlet flange) 209 is disposed below the outer tube 203 to be concentric with the outer tube 203. The manifold 209 is made of, for example, a metal material such as stainless steel (SUS) and is formed in a cylindrical shape with its upper and lower ends opened. An O-ring 220a as a seal member is installed between the upper end portion of the manifold 209 and the outer tube 203. The manifold 209 is supported by the heater base, so that the outer tube 203 is in a state of being installed vertically.

An inner tube 204 forming the reaction container is disposed inside the outer tube 203. The inner tube 204 is made of, for example, a heat resistant material such as quartz or SiC and is formed in a cylindrical shape with it upper end closed and its lower end opened. The process container (the reaction container) mainly includes the outer tube 203, the inner tube 204, and the manifold 209. A process chamber 201 is formed in a hollow cylindrical portion (inside the inner tube 204) of the process container.

The process chamber 201 is configured to be able to accommodate wafers 200 as substrates in a state where the wafers 200 are arranged in a horizontal posture and in multiple stages in a vertical direction by a boat 217 which will be described later. Nozzles 410, 420, and 430 are installed in the process chamber 201 so as to penetrate through a sidewall of the manifold 209 and the inner tube 204. Gas supply pipes 310, 320, and 330 are connected to the nozzles 410, 420, and 430, respectively.

Mass flow controllers (MFCs) 312, 322, and 332, which are flow rate controllers (flow rate control parts), are installed in the gas supply pipes 310, 320, and 330, respectively, sequentially from an upstream side. Further, valves 314, 324, and 334, which are opening/closing valves, are installed in the gas supply pipes 310, 320, and 330, respectively. Gas supply pipes 510, 520, and 530 for supplying an inert gas are connected at a downstream side of the valves 314, 324, and 334 of the gas supply pipes 310, 320, and 330, respectively. MFCs 512, 522, and 532, which are flow rate controllers (flow rate control parts), and valves 514, 524, and 534, which are opening/closing valves, are installed in the gas supply pipes 510, 520, and 530, respectively, sequentially from an upstream side.

The nozzles 410, 420, and 430 are connected to the leading ends of the gas supply pipes 310, 320, and 330, respectively. The nozzles 410, 420, and 430 are configured as L-shaped nozzles, and their horizontal portions are formed so as to penetrate through the sidewall of the manifold 209 and the inner tube 204. The vertical portions of the nozzles 410, 420, and 430 are formed inside a channel-shaped (groove-shaped) preliminary chamber 201a formed so as to protrude outward in a radial direction of the inner tube 204 and extend in a vertical direction thereof, and are also formed in the preliminary chamber 201a upward (upward in the arrangement direction of the wafers 200) along an inner wall of the inner tube 204.

The nozzles 410, 420, and 430 are installed so as to extend from a lower region of the process chamber 201 to an upper region of the process chamber 201, and a plurality of gas supply holes 410a, 420a, and 430a are formed at positions facing the wafers 200, respectively. Thus, a process gas is supplied from the gas supply holes 410a, 420a, and 430a of the respective nozzles 410, 420, and 430 to the wafers 200. A plurality of gas supply holes 410a, 420a, and 430a are formed from a lower portion of the inner tube 204 to an upper portion thereof and have the same aperture area at the same aperture pitch. However, the gas supply holes 410a, 420a, and 430a are not limited to the above-described shape. For example, an aperture area may be gradually increased from the lower portion of the inner tube 204 to the upper portion thereof. This makes it possible to make the flow rate of a gas supplied from the gas supply holes 410a, 420a, and 430a more uniform.

The plurality of gas supply holes 410a, 420a, and 430a of the nozzles 410, 420, and 430 are formed at height positions from a lower portion of the boat 217, which will be described later, to an upper portion thereof. Therefore, the process gas supplied into the process chamber 201 from the gas supply holes 410a, 420a, and 430a of the nozzles 410, 420, and 430 is supplied to the entire region of the wafers 200 accommodated from the lower portion of the boat 217 to the upper portion thereof. The nozzles 410, 420, and 430 are installed so as to extend from the lower region of the process chamber 201 to the upper region thereof, but may be installed so as to extend to the vicinity of a ceiling of the boat 217.

As a process gas, a first gas (a precursor gas or a halogen element-containing gas) containing a first element and a halogen element is supplied from the gas supply pipe 310 into the process chamber 201 via the MFC 312, the valve 314, and the nozzle 410. As the first gas, for example, a gas containing a metal element as the first element and a halogen element (a halogen-based metal-containing gas) can be used.

As a process gas, a third gas having the reducing character and containing a third element is supplied from the gas supply pipe 320 into the process chamber 201 via the MFC 322, the valve 324, and the nozzle 420.

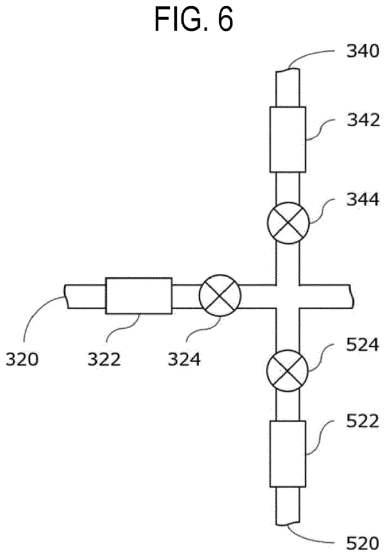

As shown in FIG. 6, a gas supply pipe 340 for supplying a fourth gas is installed at the downstream side of the valve 324 of the gas supply pipe 320 of the substrate processing apparatus of FIG. 1. Here, other elements in FIG. 6 are configured similarly to the substrate processing apparatus shown in FIG. 1, and substantially the same elements as those described in FIG. 1 are denoted by the same reference numerals, explanation of which will not be repeated. A MFC 342, which is a flow rate controller, and a valve 344, which is an opening/closing valve, are installed in the gas supply pipe 340 sequentially from an upstream side.

As a process gas, the fourth gas having the reducing character and containing a fourth element is supplied from the gas supply pipe 340 into the process chamber 201 via the MFC 342, the valve 344, the gas supply pipe 320, and the nozzle 420. Here, for reasons to be described later, the third gas may have a higher decomposition temperature than the fourth gas.

As a process gas, a second gas (a reaction gas) containing a second element different from the first element is supplied from the gas supply pipe 330 into the process chamber 201 via the MFC 332, the valve 334, and the nozzle 430.

As an inert gas, for example, a nitrogen (N₂) gas is supplied from the gas supply pipes 510, 520, and 530 into the process chamber 201 via the MFCs 512, 522, and 532, the valves 514, 524, and 534, and the nozzles 410, 420, and 430, respectively. Hereinafter, an example in which the N₂ gas is used as the inert gas will be described. However, as the inert gas, in addition to the N₂ gas, it may be possible to use, e.g., a rare gas such as an argon (Ar) gas, a helium (He) gas, a neon (Ne) gas, a xenon (Xe) gas, or the like.

A process gas supply system mainly includes the gas supply pipes 310, 320, and 330, the MFCs 312, 322, and 332, the valves 314, 324, and 334, and the nozzles 410, 420, and 430. However, the process gas supply system may include only the nozzles 410, 420, and 430. The process gas supply system may be simply referred to as a gas supply system. Further, an inert gas supply system mainly includes the gas supply pipes 510, 520, and 530, the MFCs 512, 522, and 532, and the valves 514, 524, and 534.

When the first gas is flowed from the gas supply pipe 310, a first gas supply system mainly includes the gas supply pipe 310, the MFC 312, and the valve 314. Here, the first gas supply system may include the nozzle 410. Further, when the third gas is flowed from the gas supply pipe 320, a third gas supply system mainly includes the gas supply pipe 320, the MFC 322, and the valve 324. Here, the third gas supply system may include the nozzle 420. Further, when the second gas is flowed from the gas supply pipe 330, a second gas supply system mainly includes the gas supply pipe 330, the MFC 332, and the valve 334. Here, the second gas supply system may include the nozzle 430. Further, the process gas supply system includes the gas supply pipes 310, 320, and 330, the MFCs 312, 322, and 332, the valves 314, 324, and 334, the nozzles 410, 420, and 430, the gas supply pipe 340, the MFC 342, and the valve 344. A fourth gas supply system mainly includes the gas supply pipe 340, the MFC 342, the valve 344, and the gas supply pipe 320. Here, the fourth gas supply system may include the nozzle 420.

A method of supplying a gas in the present disclosure is to transfer a gas through the nozzles 410, 420, and 430 arranged in the preliminary chamber 201a in an annular vertically long space defined by the inner wall of the inner tube 204 and ends of a plurality of wafers 200. Then, the gas is ejected into the inner tube 204 from the plurality of gas supply holes 410a, 420a, and 430a formed at positions of the nozzles 410, 420, and 430, which face the wafers. More specifically, the first gas or the like is ejected toward a direction parallel to the surface of the wafers 200 by the gas supply hole 410a of the nozzle 410, the gas supply hole 420a of the nozzle 420, and the gas supply hole 430a of the nozzle 430.

An exhaust hole (exhaust port) 204a is a through-hole formed at a position facing the nozzles 410, 420, and 430 in a sidewall of the inner tube 204. For example, the exhaust hole 204a is a slit-shaped through-hole formed elongated in the vertical direction. A gas supplied into the process chamber 201 from the gas supply holes 410a, 420a, and 430a of the nozzles 410, 420, and 430 and flowing over surfaces of the wafers 200 passes through the exhaust hole 204a and flows into an exhaust passage 206 consisting of a gap formed between the inner tube 204 and the outer tube 203. Then, the gas flowed into the exhaust passage 206 flows into an exhaust pipe 231 and is discharged to outside of the process furnace 202.

The exhaust hole 204a is formed at a position facing the plurality of wafers 200, and a gas supplied from the gas supply holes 410a, 420a, and 430a to the vicinity of the wafers 200 in the process chamber 201 flows toward the horizontal direction and then flows into the exhaust passage 206 through the exhaust hole 204a. The exhaust hole 204a is not limited to the slit-shaped through-hole, but may be configured by a plurality of holes.

The exhaust pipe 231 for exhausting an internal atmosphere of the process chamber 201 is installed in the manifold 209. A pressure sensor 245, which is a pressure detector (a pressure detecting part) for detecting an internal pressure of the process chamber 201, an APC (Auto Pressure Controller) valve 243, and a vacuum pump 246 as a vacuum-exhausting device, are connected to the exhaust pipe 231 sequentially from an upstream side. The APC valve 243 can perform or stop a vacuum-exhausting operation in the process chamber 201 by opening or closing the valve while the vacuum pump 246 is actuated, and can also adjust the internal pressure of the process chamber 201 by adjusting an opening degree of the valve while the vacuum pump 246 is actuated. An exhaust system mainly includes the exhaust hole 204a, the exhaust passage 206, the exhaust pipe 231, the APC valve 243, and the pressure sensor 245. The exhaust system may include the vacuum pump 246.

A seal cap 219 as a furnace opening cover configured to hermetically seal a lower end opening of the manifold 209 is installed under the manifold 209. The seal cap 219 is configured to come into contact with the lower end of the manifold 209 from the lower side in the vertical direction. The seal cap 219 is made of, for example, metal such as stainless steel (SUS), and is formed in a disc shape. An O-ring 220b as a seal member making contact with the lower end of the manifold 209 is installed on an upper surface of the seal cap 219. A rotator 267 for rotating the boat 217 in which the wafers 200 are accommodated is installed on the opposite side of the process chamber 201 in the seal cap 219. A rotary shaft 255 of the rotator 267 penetrates through the seal cap 219 and is connected to the boat 217. The rotator 267 is configured to rotate the wafers 200 by rotating the boat 217. The seal cap 219 is configured to be vertically moved up and down by a boat elevator 115 as an elevation mechanism vertically installed outside the outer tube 203. The boat elevator 115 is configured to be able to load/unload the boat 217 into/out of the process chamber 201 by moving the seal cap 219 up and down. The boat elevator 115 is configured as a transfer device (transfer mechanism) which transfers the boat 217 and the wafers 200 accommodated in the boat 217 into/out of the process chamber 201.

The boat 217 as a substrate support is configured to arrange a plurality of wafers 200, for example, 25 to 200 wafers 200, at intervals in the vertical direction in a horizontal posture with the centers of the wafers 200 aligned with one another. Here, the notation of a numerical range such as "25 to 200 wafers" in the present disclosure means that the lower limit value and the upper limit value are included in the range. Therefore, for example, "25 to 200 wafers" means "25 or more wafers and 200 or fewer wafers." The same applies to other numerical ranges.

The boat 217 is made of, for example, a heat resistant material such as quartz or SiC. Heat insulating plates 218 made of, for example, a heat resistant material such as quartz or SiC, are supported in a horizontal posture and in multiple stages (not shown) below the boat 217.

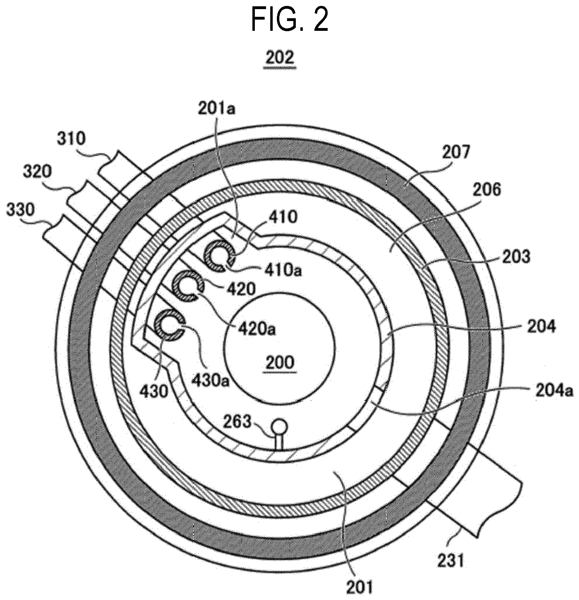

As shown in FIG. 2, a temperature sensor 263 as a temperature detector is installed in the inner tube 204. Based on temperature information detected by the temperature sensor 263, a state of supplying electric power to the heater 207 is adjusted such that the interior of the process chamber 201 has a desired temperature distribution. The temperature sensor 263 is configured as an L-shape, like the nozzles 410, 420, and 430, and is installed along the inner wall of the inner tube 204.

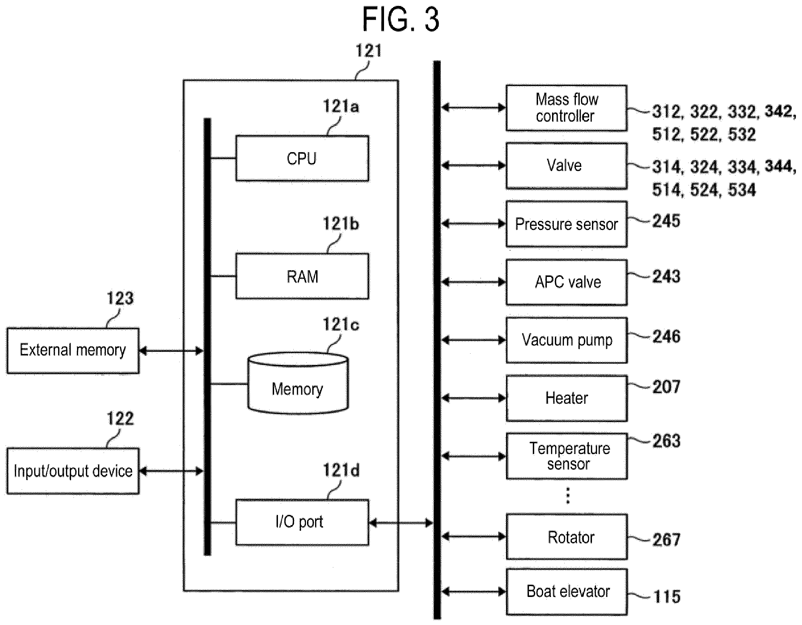

As shown in FIG. 3, a controller 121, which is a control part (control means), is configured as a computer including a CPU (Central Processing Unit) 121a, a RAM (Random Access Memory) 121b, a memory 121c, and an I/O port 121d. The RAM 121b, the memory 121c, and the I/O port 121d are configured to be capable of exchanging data with the CPU 121a via an internal bus. An input/output device 122 formed of, e.g., a touch panel or the like, is connected to the controller 121. Further, the controller 121 is configured to be able to be connected to an external memory (for example, a magnetic tape, a magnetic disk such as a flexible disk or a hard disk, an optical disc such as a CD or a DVD, a magneto-optical disc such as a MO, or a semiconductor memory such as a USB memory or a memory card) 123.

Here, the substrate processing apparatus may be configured to include one controller, or may be configured to include a plurality of controllers. That is, control for performing a substrate processing process to be described later may be performed using one controller, or may be performed using a plurality of controllers. Further, the plurality of controllers may be configured as a control system in which the plurality of controllers are connected to each other via a wired or wireless communication network, and the entire control system may perform control for performing the substrate processing process to be described later. When the term "controller" is used in the present disclosure, it may include not only one controller but also a plurality of controllers or a control system configured by a plurality of controllers.

The memory 121c is configured by, for example, a flash memory, an HDD (Hard Disk Drive), or the like. A control program for controlling operations of a substrate processing apparatus and a process recipe in which sequences and conditions of a method of manufacturing a semiconductor device, which will be described later, are written, are readably stored in the memory 121c. The process recipe functions as a program for causing the controller 121 to execute each step in the method of manufacturing a semiconductor device, which will be described later, to obtain a predetermined result. Hereinafter, the process recipe and the control program may be generally and simply referred to as a "program." When the term "program" is used herein, it may indicate a case of including a process recipe group only, a case of including a control program group only, or a case of including a combination of the process recipe and the control program. The RAM 121b is configured as a memory area (a work area) in which a program or data read by the CPU 121a is temporarily stored.

The I/O port 121d is connected to the MFCs 312, 322, 332, 342, 512, 522, and 532, the valves 314, 324, 334, 344, 514, 524, and 534, the pressure sensor 245, the APC valve 243, the vacuum pump 246, the heater 207, the temperature sensor 263, the rotator 267, the boat elevator 115, and the like.

The CPU 121a is configured to read and execute the control program from the memory 121c. The CPU 121a is also configured to read the recipe from the memory 121c according to an input of an operation command from the input/output device 122. The CPU 121a is configured to be capable of controlling the flow rate adjustment operation of various kinds of gases by the MFCs 312, 322, 332, 342, 512, 522, and 532, the opening/closing operation of the valves 314, 324, 334, 344, 514, 524, and 534, the opening/closing operation of the APC valve 243, the pressure adjusting operation performed by the APC valve 243 based on the pressure sensor 245, the temperature adjusting operation performed by the heater 207 based on the temperature sensor 263, the actuating and stopping of the vacuum pump 246, the operation of rotating the boat 217 with the rotator 267 and adjusting the rotation speed of the boat 217, the operation of moving the boat 217 up and down by the boat elevator 115, the operation of accommodating the wafers 200 in the boat 217, and the like, according to contents of the read recipe.

The controller 121 may be configured by installing, on the computer, the aforementioned program stored in the external memory 123. The memory 121c and the external memory 123 are configured as a non-transitory computer-readable recording medium. Hereinafter, the memory 121c and the external memory 123 may be generally and simply referred to as a "recording medium." When the term "recording medium" is used herein, it may indicate a case of including the memory 121c group only, a case of including the external memory 123 group only, or a case of including both the memory 121c and the external memory 123. The program may be provided to the computer using a communication means such as the Internet or a dedicated line, instead of using the external memory 123.

### (2) Substrate Processing Process

### (Film-Forming Step)

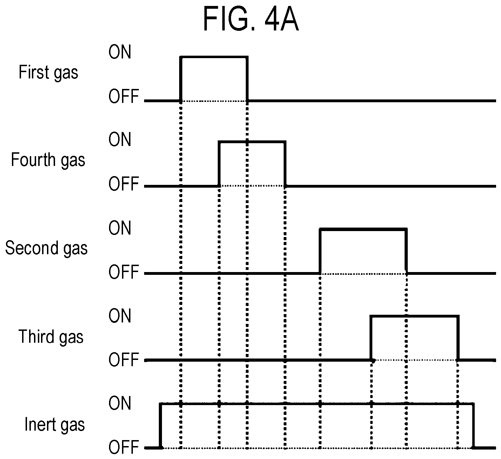

As a process of manufacturing a semiconductor device, an example of a process of forming a film on a wafer 200 will be described with reference to FIG. 4A. The process of forming a film is performed using the above-described substrate processing apparatus 10. In the following description, the operations of various parts constituting the substrate processing apparatus 10 can be controlled by the controller 121.

A substrate processing process (process of manufacturing a semiconductor device) according to the present embodiment includes:
forming a film containing a first element and a second element different from the first element on a wafer 200 by performing a process a predetermined number of times, the process including:
   (a) a step of supplying a first gas containing the first element and a halogen element to the wafer 200;
   (b) a step of supplying a second gas containing the second element to the wafer 200;
   (c) a step of supplying a third gas containing a third element and having a reducing character to the wafer 200; and
   (d) a step of supplying a fourth gas containing a fourth element and having a reducing character to the wafer 200,
wherein (a) and (d) are performed consecutively and (b) and (c) are performed consecutively.

When the term "wafer" is used in the present disclosure, it may refer to "a wafer itself" or "a wafer and a laminated body of certain layers or films formed on a surface of a wafer." When the phrase "a surface of a wafer" is used in the present disclosure, it may refer to "a surface of a wafer itself" or "a surface of a certain layer or film formed on a wafer." When the term "substrate" is used in the present disclosure, it may be synonymous with the term "wafer."

Further, in the present disclosure, "a film that does not contain a certain element A" means a film that does not substantially contain the element A. "Substantially not containing the element A" includes not only a case where the film does not contain element A at all, but also a case where the content of the element A in the film is extremely low, such as a case where the film contains almost no element A. For example, a case where the content of the element A in the film is about 4% in terms of atomic composition percentage, and preferably 4% or less in terms of atomic composition percentage, is also included.

### (Wafer Loading)

When a plurality of wafers 200 are loaded (wafer charged) in the boat 217, as shown in FIG. 1, the boat 217 supporting the plurality of wafers 200 is lifted up by the boat elevator 115 and is imported (boat loaded) into the process chamber 201. In this state, the seal cap 219 seals the lower end of the reaction tube 203 via the O-ring 220.

### (Pressure Adjustment and Temperature Adjustment)

The interior of the process chamber 201 is vacuum-exhausted by the vacuum pump 246 to reach a desired pressure (degree of vacuum). At this time, the internal pressure of the process chamber 201 is measured by the pressure sensor 245. The APC valve 243 is feedback-controlled based on the measured pressure information (pressure adjustment). The vacuum pump 246 always keeps in operation at least until processing on the wafers 200 is completed. The interior of the process chamber 201 is heated by the heater 207 to a desired temperature. At this time, the state of supplying electric power to the heater 207 is feedback-controlled based on the temperature information detected by the temperature sensor 263 such that the interior of the process chamber 201 has a desired temperature distribution (temperature adjustment). Heating the interior of the process chamber 201 by the heater 207 may be continuously performed at least until processing of the wafers 200 is completed.

### [First Step]

### (First Gas Supply)

The valve 314 is opened to allow a first gas, which is a precursor gas, to flow into the gas supply pipe 310. The flow rate of the first gas is adjusted by the MFC 312, and the first gas is supplied into the process chamber 201 from the gas supply hole 410a of the nozzle 410. At this time, the valve 514 is opened to allow an inert gas such as a N₂ gas or the like to flow into the gas supply pipe 510. The flow rate of the N₂ gas flowing through the gas supply pipe 510 is adjusted by the MFC 512, and the N₂ gas is supplied into the process chamber 201 together with the first gas.

At this time, the valves 524 and 534 are opened to allow a N₂ gas to be supplied into the process chamber 201 through the gas supply pipes 520, 530, 320, and 330 and the nozzles 420 and 430. This can prevent the first gas from entering the nozzles 420 and 430. That is, the first gas and the N₂ gas are supplied to the wafer 200. The first gas and the N₂ gas supplied into the process chamber 201 are exhausted through the exhaust pipe 231.

At this time, the APC valve 243 is adjusted so that the internal pressure of the process chamber 201 falls within a range of, for example, 1 to 3,990Pa. A supply flow rate of the first gas controlled by the MFC 312 is set to fall within a range of, for example, 0.1 to 2.0slm. A supply flow rate of the N₂ gas controlled by the MFCs 512, 522, and 532 is set to fall within a range of, for example, 0.1 to 20slm. At this time, the temperature of the heater 207 is set so that the temperature of the wafer 200 falls within a range of, for example, 300 to 600 degrees C.

At this time, the gases flowing into the process chamber 201 are only the first gas and the N₂ gas. By supplying the first gas, a first element-containing layer is formed on the wafer 200 (or a base film on the surface of the wafer 200). The first element-containing layer may be a first element layer containing a halogen element or a first gas adsorption layer, or may include both of them.

### (Fourth Gas Supply)

After a predetermined period of time has elapsed from a start of the supply of the first gas, for example after 0.01 to 5 seconds, the valve 344 is opened to allow a fourth gas to flow into the gas supply pipe 340. Here, the flow rate of the fourth gas is adjusted by the MFC 342, and the fourth gas is supplied into the process chamber 201 from the gas supply hole 420a of the nozzle 420 through the gas supply pipe 320.

At the same time, the valve 524 is opened to allow an inert gas such as a N₂ gas or the like to flow into the gas supply pipe 520. The flow rate of the N₂ gas flowing through the gas supply pipe 520 is adjusted by the MFC 522, and the N₂ gas is supplied into the process chamber 201 together with the fourth gas. At this time, the valves 524 and 534 are opened to allow a N₂ gas to be supplied into the process chamber 201 via the gas supply pipes 520, 530, 320, and 330 and the nozzles 420 and 430. That is, the first gas, the fourth gas, and the N₂ gas are supplied to the wafer 200.

At this time, the APC valve 243 is adjusted so that the internal pressure of the process chamber 201 falls within a range of, for example, 1 to 3,990Pa. The supply flow rate of the second gas controlled by the MFC 312 is set to fall within a range of, for example, 0.1 to 2.0slm. The supply flow rate of the N₂ gas controlled by the MFCs 512, 522, and 532 and the temperature of the heater 207 are set to be the same as, for example, when the first gas is supplied.

After a predetermined period of time has elapsed from the start of the supply of the first gas, for example after 0.01 to 10 seconds, the valve 314 of the gas supply pipe 310 is closed to stop the supply of the first gas. That is, the period of time for supplying the first gas to the wafer 200 is set to fall within a range of, for example, 0.01 to 10 seconds. At this time, in order to prevent the fourth gas from entering the nozzles 410 and 430, the valves 514 and 534 are opened to allow a N₂ gas to flow into the gas supply pipes 510 and 530. At this time, the fourth gas and the N₂ gas are supplied to the wafer 200.

At this time, the APC valve 243 is adjusted so that the internal pressure of the process chamber 201 falls within a range of, for example, 130 to 3,990Pa. By setting the pressure within such a range, a film that does not contain the fourth element can be formed. Further, a supply flow rate of the fourth gas controlled by the MFC 342 is set to fall within a range of, for example, 0.1 to 5slm. The supply flow rate of the N₂ gas controlled by the MFCs 512, 522, and 532 and the temperature of the heater 207 are set to be the same as, for example, when the first gas is supplied.

In the first step, the supply of the fourth gas is started at the same time as the stop of the supply of the first gas or before the stop of the supply of the first gas. As a result, the step of supplying the first gas to the wafer 200 and the step of supplying the fourth gas to the wafer 200 are performed consecutively. In other words, in the first step, at least one selected from the group of the first gas and the fourth gas remains present in the process chamber 201.

### [Second Step]

### (Residual Gas Removal)

After a predetermined period of time has elapsed from the start of the supply of the fourth gas, for example after 0.01 to 10 seconds, the valve 344 is closed to stop the supply of the fourth gas. The interior of the process chamber 201 may be vacuum-exhausted by the vacuum pump 246 with the APC valve 243 of the exhaust pipe 231 left open. At this time, the first gas remaining in the process chamber 201 that remains unreacted or has contributed to the formation of the first element-containing layer, or the fourth gas remaining in the process chamber 201 that remains unreacted or has reacted with by-products is removed from the interior of the process chamber 201. At this time, the supply of the N₂ gas into the process chamber 201 may be maintained with the valves 514, 524, and 534 left open. This N₂ gas acts as a purge gas, whereby the effect of removing from the interior of the process chamber 201 the first gas remaining in the process chamber 201 that remains unreacted or has contributed to the formation of the first element-containing layer or the fourth gas remaining in the process chamber 201 that remains unreacted or has reacted with by-products can be enhanced.

### [Third Step]

### (Second Gas Supply)

After removing the residual gas, the valve 334 is opened to allow a second gas, which is a reaction gas, to flow into the gas supply pipe 330. The flow rate of the second gas is adjusted by the MFC 332, and the second gas is supplied into the process chamber 201 from the gas supply hole 430a of the nozzle 430. At the same time, the valve 534 is opened to allow an inert gas such as a N₂ gas to flow into the gas supply pipe 530. The flow rate of the N₂ gas flowing through the gas supply pipe 530 is adjusted by the MFC 532, and the N₂ gas is supplied into the process chamber 201 together with the second gas. At this time, the gases flowing into the process chamber 201 are only the second gas and the N₂ gas.

At this time, the valves 514 and 524 are opened to allow an N₂ gas to be supplied into the process chamber 201 through the gas supply pipes 510, 520, 310, and 320 and the nozzles 410 and 420. This can prevent the second gas from entering the nozzles 410 and 420. That is, the second gas and the N₂ gas are supplied to the wafer 200.

At this time, the APC valve 243 is adjusted so that the internal pressure of the process chamber 201 falls within a range of, for example, 1 to 3,990Pa. The supply flow rate of the second gas controlled by the MFC 312 is set to fall within a range of, for example, 0.1 to 2.0slm. The supply flow rate of the N₂ gas controlled by the MFCs 512, 522, and 532 and the temperature of the heater 207 are set to be the same as, for example, when the first gas is supplied.

The second gas supplied into the process chamber 201 reacts with at least a portion of the first element-containing layer on the wafer 200. As a result, a layer containing the first element and the second element (first/second element-containing layer) is formed on the wafer 200.

### (Third Gas Supply)

After a predetermined period of time has elapsed from the start of the supply of the second gas, for example after 0.01 to 5 seconds, the valve 324 is opened to allow a third gas, which is a reducing gas, to flow into the gas supply pipe 320. Here, the flow rate of the third gas is adjusted by the MFC 322, and the third gas is supplied into the process chamber 201 from the gas supply hole 420a of the nozzle 420. At the same time, the valve 524 is opened to allow an inert gas such as a N₂ gas or the like to flow into the gas supply pipe 520. The flow rate of the N₂ gas flowing through the gas supply pipe 520 is adjusted by the MFC 522, and the N₂ gas is supplied into the process chamber 201 together with the third gas.

At this time, the valve 514 is opened to allow a N₂ gas to be supplied into the process chamber 201 through the gas supply pipes 510 and 310 and the nozzle 410. This can prevent the second gas and the third gas from entering the nozzle 410. That is, the second gas, the third gas, and the N₂ gas are supplied to the wafer 200.

At this time, the APC valve 243 is adjusted so that the internal pressure of the process chamber 201 falls within a range of, for example, 130 to 3,990Pa. By setting the pressure within such a range, a film that does not contain the third element can be formed. Further, a supply flow rate of the third gas controlled by the MFC 322 is set to fall within a range of, for example, 0.1 to 5slm. The supply flow rate of the N₂ gas controlled by the MFCs 512, 522, and 532 and the temperature of the heater 207 are set to be the same as, for example, when the first gas is supplied.

After a predetermined period of time has elapsed from the start of the supply of the second gas, for example after 0.01 to 60 seconds, the valve 334 of the gas supply pipe 330 is closed to stop the supply of the second gas. That is, the period of time for supplying the second gas to the wafer 200 is set to fall within a range of, for example, 0.01 to 10 seconds. At this time, in order to prevent the third gas from entering the nozzles 410 and 430, the valves 514 and 534 are opened to allow a N₂ gas to flow into the gas supply pipes 510 and 530. At this time, the third gas and the N₂ gas are supplied to the wafer 200.

At this time, the APC valve 243 is adjusted so that the internal pressure of the process chamber 201 falls within a range of, for example, 130 to 3,990Pa. Further, the supply flow rate of the third gas controlled by the MFC 322 is set to fall within a range of, for example, 0.1 to 5slm. The supply flow rate of the N₂ gas controlled by the MFCs 512, 522, and 532 and the temperature of the heater 207 are set to be the same as, for example, when the first gas is supplied.

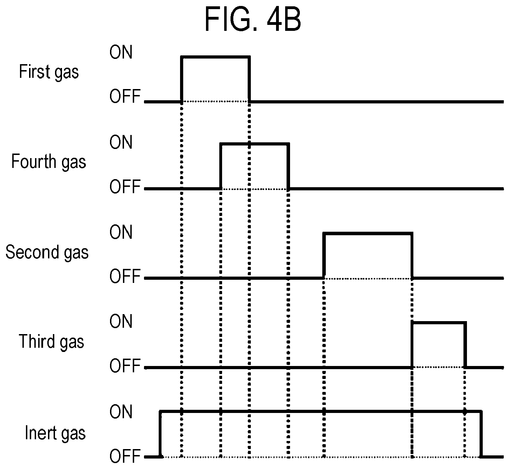

In the third step, the supply of the third gas is started before the stop of the supply of the second gas, or as shown in a gas supply timing shown in FIG. 4B (described later as Modification 1 of the embodiment), the supply of the third gas is started at the same time as the stop of the supply of the second gas. As a result, the step of supplying the second gas to the wafer 200 and the step of supplying the third gas to the wafer 200 are performed consecutively. In other words, in the third step, a state where at least one selected from the group of the second gas and the third gas exists in the process chamber 201 is maintained.

### [Fourth Step]

### (Residual Gas Removal)

After a predetermined period of time has elapsed from the start of the supply of the third gas, for example after 0.01 to 10 seconds, the valve 324 is closed to stop the supply of the third gas. Then, according to the same processing procedure as the above-described second step, the second gas or reaction by-products remaining in the process chamber 201 that remains unreacted or has contributed to the formation of the first/second element-containing layer or the third gas remaining in the process chamber 201 that remains unreacted or has reacted with by-products is removed from the process chamber 201.

### (Performing Predetermined Number of Times)

By performing a cycle one or more times (a predetermined number of times (n times)), the cycle including sequentially performing the first to fourth steps, a film having a predetermined thickness (for example, 0.5 to 5.0nm) and containing the first element and the second element is formed. The above cycle may be repeated a plurality of times. At this time, by performing the first step and the third step under the above-mentioned conditions, it is possible to form a film containing the first element and the second element but not containing the third element and/or the fourth element.

### (After-Purging and Returning to Atmospheric Pressure)

A N₂ gas is supplied into the process chamber 201 from each of the gas supply pipes 510, 520, and 530 and is exhausted through the exhaust pipe 231. The N₂ gas acts as a purge gas, whereby the interior of the process chamber 201 is purged with the inert gas to remove a gas and reaction by-products remaining in the process chamber 201 from the process chamber 201 (after-purging). After that, the internal atmosphere of the process chamber 201 is substituted with the inert gas (inert gas substitution), and the internal pressure of the process chamber 201 is returned to an atmospheric pressure (returning to atmospheric pressure).

### (Wafer Unloading)

After that, the seal cap 219 is moved down by the boat elevator 115 to open the lower end of the reaction tube 203. Then, the processed wafers 200 supported by the boat 217 are unloaded from the lower end of the reaction tube 203 to the outside of the reaction tube 203 (boat unloading). After that, the processed wafers 200 are discharged from the boat 217 (wafer discharging).

When a substance containing a halogen element is used as the first gas, by-products containing a halogen element are generated during formation of the first element-containing layer and/or the first/second element-containing layer. Further, for example, when the second gas contains H, for example, hydrogen halide is generated as by-products containing a halogen element. Such by-products may inhibit a reaction between the first gas and/or the second gas and the surface of the wafer 200. In other words, the more such by-products exist on the wafer 200 or in the process chamber 201, the more the formation of the first element-containing layer and/or the first/second element-containing layer is inhibited, so that a deposition rate tends to decrease.

In the first step, the fourth gas reacts with the by-products (or reduces the by-products) generated during the formation of the first element-containing layer, and is discharged, as a halogenated fourth element, from the process chamber 201. Further, in the third step, the third gas reacts with the by-products (or reduces the by-products) generated during the formation of the first/second element-containing layer), and is discharged, as a halogenated third element, from the process chamber 201. As a result, in the first and third steps, the amount of by-products present on the wafer 200 and in the process chamber 201 is reduced, so that the deposition rate can be improved.

In the first step of the embodiment, the supply of the second gas and the supply of the third gas are performed consecutively. At this time, as compared to a case where the supply of the second gas and the supply of the third gas are not performed consecutively, the time from when the by-products are generated until they react with the third gas is shorter. As a result, the amount of by-products adsorbed on the surface of the wafer 200 can be further reduced, so that the deposition rate can be improved. For this reason, purging the process chamber 201 with an inert gas between the supply of the second gas and the supply of the third gas may not be performed. Further, the interior of the process chamber 201 may not be exhausted while the second gas or the third gas is not being supplied to the wafer 200.

The same process applies in the third step. That is, by performing the supply of the second gas and the supply of the third gas consecutively, the deposition can be improved. Further, purging the process chamber 201 with an inert gas between the supply of the first gas and the supply of the fourth gas may not be performed, or the interior of the process chamber 201 is not exhausted while the first gas or the fourth gas is not being supplied to the wafer 200.

In the embodiment, the third element in the third gas that is supplied consecutively to the second gas tends to be introduced into the film more easily than the fourth element in the fourth gas that is supplied consecutively to the first gas. However, if both the third gas and the fourth gas are stable gases that are difficult to be introduced into the film, although it is possible to suppress the third gas from being introduced into the film, the effect of removing the by-products during the supply of the first gas tends to be reduced. For this reason, the third gas may be set to be as a gas with a higher decomposition temperature (a more stable gas or a gas with lower reactivity) than the fourth gas, for forming a film containing the first element and the second element and not containing the third element. As a result, while making it difficult for the third gas to be introduced into the film, it is possible to make it difficult to reduce the effect of removing the by-products generated during the supply of the first gas.

### (3) Modifications

FIG. 4B is a diagram showing a timing of gas supply in Modification 1 of the embodiment. As shown in FIG. 4B, the supply of the third gas may be started simultaneously with an end of the supply of the second gas. In this case, the deposition rate can be improved as in the embodiment.

Here, the longer the time for which both the second gas and the third gas are supplied, the higher the content rate of the third element in the film tends to be. However, as described above, in order to improve the deposition rate, it the supply of the second gas and the supply of the third gas may be performed consecutively. For this reason, by starting the supply of the third gas simultaneously with the end of the supply of the second gas, a film containing the first element and the second element and not containing the third element can be formed easily at a good deposition rate.

In contrast, the fourth element in the fourth gas that is supplied consecutively to the first gas tends to be difficult to be introduced into the film than the third element in the third gas that is supplied consecutively to the second gas. Further, when the supply of the first gas and the supply of the fourth gas are performed at least partially simultaneously, the time period from when the by-products are generated due to the reaction of the first gas to when they react with the fourth gas is longer compared to when the supply of the fourth gas is started simultaneously with the end of the supply of the first gas. For this reason, by partially simultaneously performing the supply of the first gas and the supply of the fourth gas, the deposition rate when forming a film containing the first element and the second element and not containing the fourth element can be improved easily.

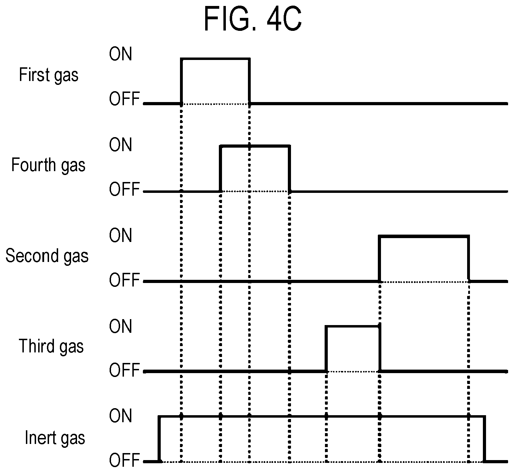

FIG. 4C is a diagram showing a timing of gas supply in Modification 2 of the embodiment. As shown in FIG. 4C, the supply of the second gas may be started simultaneously with an end of the supply of the third gas. Further, in a state where the supply of the third gas and the supply of the second gas are performed consecutively, the supply of the second gas may be started while the third gas is being supplied. In this case as well, the deposition rate can be improved as in the embodiment.

Further, the first element-containing layer before reacting with the second gas tends to react with the third gas more easily than after reacting with the second gas. Therefore, in Modification 2 in which the third gas reaches the first element-containing layer earlier than the second gas, the third element content rate of the film tends to be higher than in Modification 1. That is, when forming a film containing the first element and the second element and not containing the third element, the supply of the third gas may be started after the start of the supply of the second gas, as in the embodiment and Modification 1, rather than to start the supply of the second gas after the start of the supply of the third gas as in Modification 2.

Experimental examples will be explained below. However, the present disclosure is not limited to these experimental examples.

### <Experimental Examples>

In this experimental example, a titanium nitride (TiN) film was formed using the substrate processing apparatus 10 used in the above-described embodiment under conditions to be described below. In this experimental example, the first gas is a gas containing titanium (Ti) and a halogen element as the first element, the second gas is a N-containing gas containing nitrogen (N) as the second element, the third gas is a gas containing a Group XV element as the third element and having the reducing character, and the fourth gas is a gas containing a Group XIV element as the fourth element and having the reducing character.

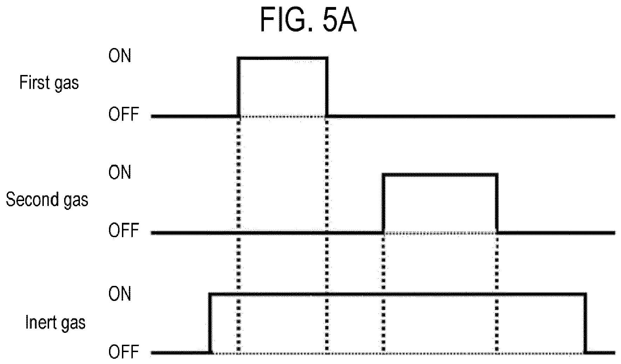

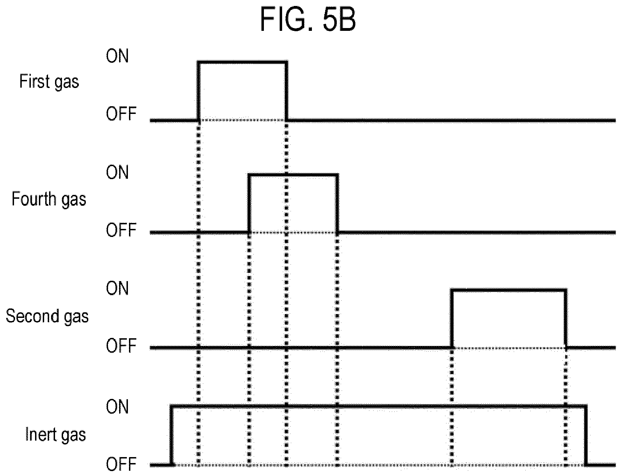

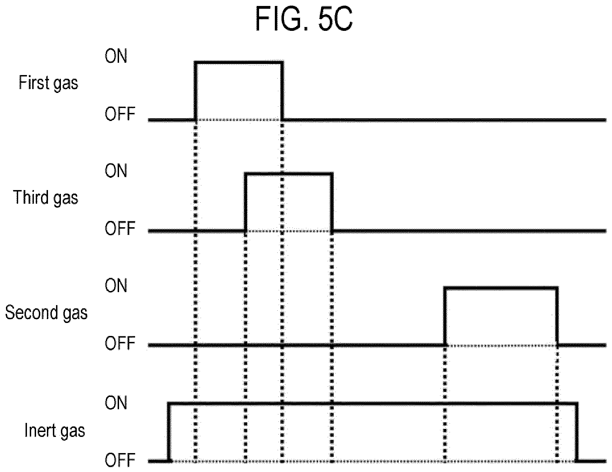

A TiN film was formed on a substrate under Condition 1 using the gas supply timing shown in FIG. 4B described as Modification 1, and under Condition 2 using the gas supply timing shown in FIG. 4C described as Modification 2. Further, as Comparative Example 1, a TiN film was formed on a substrate using a gas supply timing shown in FIG. 5A. Specifically, in Comparative Example 1, the TiN film was formed by performing a cycle a predetermined number of times, the cycle including the first gas supply, the residual gas removal, the second gas supply, and the residual gas removal. Further, as Comparative Example 2, a TiN film was formed on a substrate using a gas supply timing shown in FIG. 5B. Specifically, in Comparative Example 2, the TiN film was formed by performing a cycle a predetermined number of times, the cycle including the first gas supply, the simultaneous supply of the first gas and the fourth gas, the fourth gas supply, the residual gas removal, the second gas supply, and the residual gas removal. Further, as Comparative Example 3, a TiN film was formed on a substrate using a gas supply timing shown in FIG. 5C. Specifically, in Comparative Example 3, the TiN film was formed by performing a cycle a predetermined number of times, the cycle including the first gas supply, the simultaneous supply of the first gas and the third gas, the third gas supply, the residual gas removal, the second gas supply, and the residual gas removal. Further, conditions other than the gas supply timing are within the ranges exemplified in the above-described embodiment.

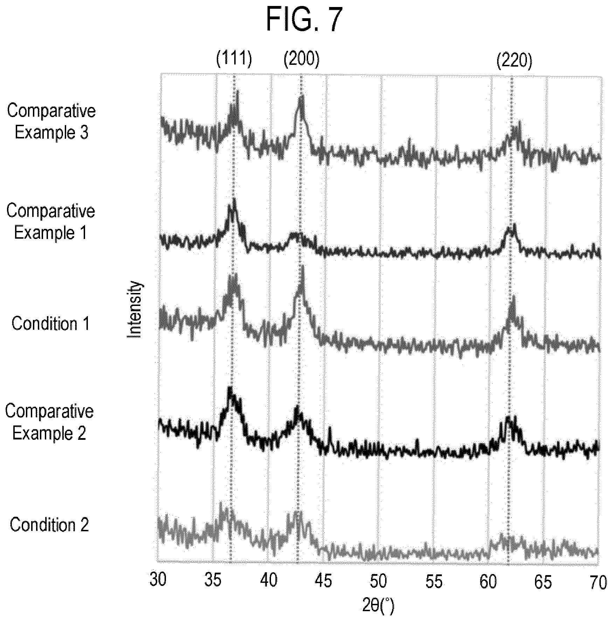

FIG. 7 shows the results of X-ray diffraction (XRD) measurements performed on these TiN films.

In the TiN film of Comparative Example 1, an intensity of 111 diffraction of the TiN crystal is lower than the intensity of 200 diffraction of the TiN crystal. From this, it can be seen that in the TiN film, a proportion of TiN crystal grains growing toward the {111} plane in a direction perpendicular to the surface of the wafer 200 is greater than that of the { 100} plane. That is, the {111} plane has a dominant crystal orientation. In the TiN film with the dominant crystal orientation of the {111} plane, gaps are easily formed between crystal grains, and when a liquid or gas enters these gaps, substances such as oxides other than TiN may be generated, which may lead to deterioration of film quality. Therefore, such a TiN film tends to have poor film quality and high electrical resistance. In other words, by providing a crystal orientation in which planes other than the {111} plane are dominant, the film quality and electrical resistance of the TiN film can be improved.

In the TiN film of Comparative Example 2, the intensity of the 200 diffraction line relative to the intensity of the 111 diffraction is higher than that of the TiN film of Comparative Example 1. From this, it can be seen that the number of TiN crystal grains oriented in the { 100} plane increased. Therefore, by consecutively supplying the first gas and the fourth gas as in Comparative Example 2, the film quality of the TiN film can be improved.

Similarly, in the TiN film of Comparative Example 3, the intensity of the 200 diffraction line relative to the intensity of the 111 diffraction is higher than that of the TiN film of Comparative Example 1. That is, by consecutively supplying the first gas and the third gas as in Comparative Example 3, the film quality of the TiN film can be improved.

Further, in the TiN film of Comparative Example 3, the intensity of the 200 diffraction line relative to the intensity of the 111 diffraction is higher than that of the TiN film of Comparative Example 2. Therefore, it is more effective for improving the film quality of the TiN film to consecutively supply the first gas and the third gas as in Comparative Example 3 than to consecutively supply the first gas and the fourth gas as in Comparative Example 2.

Further, in the TiN films of Conditions 1 and 2, the intensity of the 200 diffraction line relative to the intensity of the 111 diffraction is higher than that of the TiN film of Comparative Example 2. Therefore, as in Conditions 1 and 2, by consecutively supplying the second gas and the third gas and by consecutively supplying the first gas and the fourth gas, the film quality of the TiN film can be improved.

Further, in the TiN film of Condition 1, the intensity of the 200 diffraction line relative to the intensity of the 111 diffraction is higher than that of the TiN film of Condition 2. In addition, in the TiN film of Condition 1, the width of the diffraction peak relative to the height thereof is larger than that of the TiN film of Condition 2. From this, it can be seen that the TiN film of Condition 2 is in a state closer to an amorphous state than the TiN film of Condition 1. In other words, it can be seen that the TiN film of Condition 1 has better crystallinity than the TiN film of Condition 2. Therefore, when consecutively performing the supply of the second gas and the supply of the third gas, the supply of the third gas may be started after the start of the supply of the second gas as in Condition 1 rather than starting the supply of the second gas after the start of the supply of the third gas as in Condition 2.

From the above, in the step of forming the TiN film, the third gas and/or the fourth gas function as a modifying gas that increases a proportion of TiN crystal grains oriented in a predetermined crystal plane in the formed TiN film. Therefore, the step of supplying the third gas and/or the fourth gas may be regarded as a step of modifying the TiN film.

In the experimental example, the gas containing Ti, which is a metal element, and a halogen element was used as the first gas (precursor gas) containing the first element and the halogen element. However, the present disclosure is not limited thereto. For example, as the first element, metal elements such as tantalum (Ta), tungsten (W), cobalt (Co), yttrium (Y), ruthenium (Ru), aluminum (Al), hafnium (Hf), zirconium (Zr), molybdenum (Mo), niobium (Nb), manganese (Mn), nickel (Ni), silicon (Si), or the like may be used. Further, as the halogen element, fluorine (F), chlorine (Cl), bromine (Br), iodine (I), or the like may be used.

Examples of the gas containing a halogen element and a metal element as the first gas may include tantalum pentachloride (TaCl₅), tantalum pentafluoride (TaF₅), tungsten hexachloride (WCl₆), tungsten hexafluoride (WF₆), titanium tetrafluoride (TiF₄), cobalt dichloride (CoCl₂), cobalt difluoride (CoF₂), yttrium trichloride (YCl₃), yttrium trifluoride (YF₃), ruthenium trichloride (RuCl₃), ruthenium trifluoride (RuF₃), aluminum trichloride (AlCl₃), aluminum trifluoride (AlF₃), hafnium tetrachloride (HfCl₄), hafnium tetrafluoride (HfF4), zirconium tetrachloride (ZrCl₄), zirconium tetrafluoride (ZrF₄), molybdenum pentafluoride (MoFs), molybdenum pentachloride (MoCls), niobium trifluoride (NbF₃), niobium trichloride (NbCl₃), manganese difluoride (MnF₂), manganese dichloride (MnCl₂), nickel difluoride (NiF₂), nickel dichloride (NiCl₂), tetrachlorosilane (SiCl₄), dichlorosilane (SiH₂Cl₂), monochlorosilane (SiH₃Cl), hexachlorodisilane (Si₂Cl₆), and the like, which can be used to form various types of films. One or more of these can be used as the first gas.

In the experimental example, the N-containing gas (nitriding gas) containing N as the second element was used as the second gas (precursor gas). However, the present disclosure is not limited thereto. As the second element, for example, an oxygen (O), which is a Group XVI element, can be used. As the second gas, for example, an O-containing gas (oxidizing gas) containing O as the second element can be used.

As the N-containing gas as the second gas, for example, a N- and hydrogen (H)-containing gas or a carbon (C)- and N-containing gas can be used. As the N- and H-containing gas, for example, a hydrogen nitride-based gas containing a N-H bond can be used. Specifically, ammonia (NH₃), hydrazine (N₂H₄), diazene (N₂H₂), N₃H₈, etc. can be used as the N- and H-containing gas. Further, as the C- and N-containing gas, an amine gas or an organic hydrazine-based gas can be used. Further, for example, monoethylamine (C₂H₅NH₂), diethylamine ((C₂H₅)₂NH), triethylamine ((C₂H₅)₃N), monomethylamine (CH₃NH₂), dimethylamine ((CH₃)₂NH), trimethylamine ((CH₃)₃N), etc. can be used as the C- and N-containing gas. Further, for example, monomethylhydrazine ((CH₃)HN₂H₂), dimethylhydrazine ((CH₃)₂N₂H₂), trimethylhydrazine ((CH₃)₂N₂(CH₃)H), etc. can be used as the C- and N-containing gas. One or more of these can be used as the second gas.

Further, examples of the O-containing gas as the second gas may include an oxygen (O₂) gas, a nitrous oxide (N₂O) gas, a nitric oxide (NO) gas, a nitrogen dioxide (NO₂) gas, an ozone (O₃) gas, water vapor (H₂O gas), a carbon monoxide (CO) gas, a carbon dioxide (CO₂) gas, an O₂ gas+hydrogen (H₂) gas, an O₃ gas+H₂ gas, a H₂O gas+H₂ gas, and the like. Further, in the present disclosure, the description of two gases together such as "O₃ gas+H₂ gas" means a mixed gas of an O₃ gas and a H₂ gas. One or more of these can be used as the second gas.

In the experimental example, the gas containing a Group XV element as the third element and having the reducing character was used as the third gas, the gas containing a Group XIV element as the fourth element and having the reducing character was used as the fourth gas. However, the present disclosure is not limited thereto. As the third element and/or the fourth element, for example, a Group XIII element, a Group XIV element, or a Group XV element can be used.

Further, a Group XV element may be used as the third element. This makes it difficult for the third element to be introduced into the film. Furthermore, P, which is a Group XV element, may be used as the third element. This further makes it difficult for the third element to be introduced into the film. Furthermore, when using a Group XV element as the third element, a Group XIV element may be used as the fourth element. This further makes it difficult for the fourth element to be introduced into the film.

As the Group XIII element, for example, boron (B) can be used. As the Group XIV element, for example, C, Si, or Ge can be used. As the Group XV element, for example, N or P can be used. However, when forming a film that does not contain the third element and/or the fourth element, an element different from the first element and the second element may be used, as the third element and/or the fourth element.

Further, the above-described effects can be obtained even if a gas containing the third element and H or a gas containing the fourth element and H is used. As such a gas, for example, a gas containing a bond between the third element and hydrogen in one molecule or a gas containing a bond between the fourth element and hydrogen in one molecule can be used. As such a gas, for example, a gas containing only the third element and hydrogen in one molecule or a gas containing a bond between the fourth element and hydrogen in one molecule can be used. When by-products containing a halogen element is removed by the third gas and/or the fourth gas, a gas that does not contain a halogen element may be used.

As the above-mentioned gases, for example, one or more selected from the group of borane (BH₃), diborane (B₂H₆), methane (CH₄), ethane (C₂H₆), monosilane (SiH₄), disilane (Si₂H₆), monogermane (GeH₄), digermane (Ge₂H₆), NH₃, N₂H₄, phosphine (PH₃), diphosphine (P₂H₄), and the like can be used as the third gas and the fourth gas. Further, one or more may be selected from the group of these gases such that the third gas has a higher decomposition temperature than the fourth gas.

Further, in the embodiments, their modifications, and the experimental example, a configuration has been described in which the third gas and the fourth gas are supplied into the process chamber 201 from the common nozzle 420. However, the present disclosure is not limited thereto. The present disclosure can also be applied to a case where the third gas and the fourth gas are supplied into the process chamber 201 from individual nozzles.

Further, in the embodiments, the modifications, and the experimental example, a configuration has been described in which a film is formed using a batch-type substrate processing apparatus capable of processing a plurality of substrates at a time. However, the present disclosure is not limited thereto, but may also be suitably applied to a case where a film is formed using a substrate processing apparatus capable of processing a single substrate or several substrates at a time. In addition, an example in which a film is formed using a substrate processing apparatus including a hot-wall-type process furnace has been described in the above-described embodiments. The present disclosure is not limited to the above-described embodiments, but may also be suitably applied to a case where a film is formed using a substrate processing apparatus including a cold-wall-type process furnace.

Even in the case of using these substrate processing apparatuses, each process can be performed according to the same processing procedures and process conditions as those in the above-described embodiments, modifications, and experimental example, and the same effects as those of the above-described embodiments, modifications, and experimental example can be obtained.

The embodiments, their Modification 1 and Modification 2, and Comparative Example 1, Comparative Example 2, and Comparative Example 3 in the experimental example have been described above. However, the present disclosure is not limited to these embodiments, and may be used in proper combination.

According to the present disclosure in some embodiments, it is possible to improve the deposition rate.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the disclosures. The accompanying claims and their equivalents are intended to cover such forms or modifications as would fall within the scope of the disclosures.

## Claims

1. A method of processing a substrate (200), comprising:
forming a film containing a first element and a second element different from the first element on the substrate (200) by performing a process a predetermined number of times, the process including:
(a) supplying a first gas containing the first element and a halogen element to the substrate (200);
(b) supplying a second gas containing the second element to the substrate (200);
(c) supplying a third gas containing a third element and having a reducing character to the substrate (200); and
(d) supplying a fourth gas containing a fourth element and having a reducing character to the substrate (200),
wherein (a) and (d) are performed consecutively, and (b) and (c) are performed consecutively.

2. The method of Claim 1, wherein the third gas has a higher decomposition temperature than the fourth gas.

3. The method of Claim 1, wherein the film does not contain at least one selected from the group of the third element and the fourth element.

4. The method of Claim 1, wherein between (b) and (c), a state, in which at least one selected from the group of the second gas and the third gas exists in a space where the substrate (200) exists, is maintained.

5. The method of Claim 1, wherein (c) is started after a start of (b).

6. The method of Claim 1, wherein (b) is started after a start of (c).

7. The method of Claim 6, wherein (a) and (d) are performed at least partially simultaneously.

8. The method of Claim 1, wherein the third gas is a modifying gas that increases a proportion of crystal grains oriented in a predetermined crystal plane in the film.

9. The method of Claim 1, wherein the fourth gas is a modifying gas that increases a proportion of crystal grains oriented in a predetermined crystal plane in the film.

10. The method of any one of Claims 1 to 9, wherein the first element is a metal element, and the film is a metal element-containing film.

11. The method of any one of Claims 1 to 9, wherein the third element is a Group XIII element, a Group XIV element, or a Group XV element.

12. The method of any one of Claims 1 to 9, wherein the fourth element is a Group XIII element, a Group XIV element, or a Group XV element.

13. A method of manufacturing a semiconductor device, comprising the method of Claim 1.

14. A substrate processing apparatus (10) comprising:
a first gas supply system configured to supply a first gas containing a first element and a halogen element to a substrate (200);
a second gas supply system configured to supply a second gas containing a second element different from the first element to the substrate (200);
a third gas supply system configured to supply a third gas containing a third element and having a reducing character to the substrate (200);
a fourth gas supply system configured to supply a fourth gas containing a fourth element and having a reducing character to the substrate (200); and
a controller (121) configured to be capable of controlling the first gas supply system, the second gas supply system, the third gas supply system, and the fourth gas supply system so as to form a film containing the first element and the second element on the substrate (200) by performing a process a predetermined number of times, the process including:
(a) supplying the first gas to the substrate (200);
(b) supplying the second gas to the substrate (200);
(c) supplying the third gas to the substrate (200); and
(d) supplying the fourth gas to the substrate (200),
wherein (a) and (d) are performed consecutively, and (b) and (c) are performed consecutively.

15. A program that causes, by a computer, a substrate processing apparatus (10) to perform a process comprising:
forming a film containing a first element and a second element different from the first element on a substrate (200) by performing a process a predetermined number of times, the process including:
(a) supplying a first gas containing the first element and a halogen element to the substrate (200);
(b) supplying a second gas containing the second element to the substrate (200);
(c) supplying a third gas containing a third element and having a reducing character to the substrate (200); and
(d) supplying a fourth gas containing a fourth element and having a reducing character to the substrate (200),
wherein (a) and (d) are performed consecutively, and (b) and (c) are performed consecutively.
